# EUROPEAN PATENT APPLICATION

(11) **EP 4 819 780 A1**
(43) Date of publication of application: **07.10.2026**
(21) Application number: 24915532.6
(22) Date of filing: 25.11.2024
(51) Int. Cl.: H05K 7/20, H01L 23/373, H01L 23/427, H04M 1/02

(54) **ELECTRONIC DEVICE COMPRISING PRINTED CIRCUIT BOARD INCLUDING THERMAL INTERFACE MATERIAL**

(30) Priority: 02.01.2024 KR 20240000607; 16.01.2024 KR 20240007064
(71) Applicant: Samsung Electronics Co., Ltd., Suwon-si, Gyeonggi-do 16677 (KR)
(72) Inventor: LEE, Haejin, Suwon-si Gyeonggi-do 16677 (KR); PARK, Min, Suwon-si Gyeonggi-do 16677 (KR); PARK, Yisu, Suwon-si Gyeonggi-do 16677 (KR); SON, Jihyeon, Suwon-si Gyeonggi-do 16677 (KR); YE, Jaeheung, Suwon-si Gyeonggi-do 16677 (KR); JUNG, Jinhwan, Suwon-si Gyeonggi-do 16677 (KR)
(74) Representative: HGF
(86) International application number: PCT/KR2024/018783
(87) International publication number: WO 2025/146949

(57) **Abstract**

An electronic device, according to one embodiment, comprises: a housing; a first printed circuit board; a second printed circuit board; an interposer forming a space between the first printed circuit board and the second printed circuit board; a first electronic component disposed on the first printed circuit board; a plurality of second electronic components disposed on the first printed circuit board and positioned in the space; and a thermal interface material (TIM) included within the space. The thermal interface material is spaced apart from at least one of the plurality of second electronic components.

## Description

### [Technical Field]

The disclosure relates to an electronic device including a printed circuit board including a thermal interface material.

### [Background Art]

An electronic device may include a plurality of electronic components to implement various functions. The plurality of electronic components may generate heat by consuming electric power when operating. The heat generated from the electronic components may increase the temperature of the electronic components, thereby causing performance degradation of the electronic device. The electronic device may include a component for dissipating the heat generated from the electronic components. For example, the electronic device may include a thermal interface material (TIM) configured to transfer heat. Heat generated from the electronic components may be diffused through the thermal interface material.

The above information may be presented as related art only to assist with an understanding of the disclosure. No determination has been made, and no assertion is made, as to whether any of the above might be applicable as prior art with regard to the disclosure.

### [Detailed Description of Invention]

### [Technical Solution]

An electronic device is provided. The electronic device may include a first printed circuit board including a first surface and a second surface opposite to the first surface. The electronic device may include a second printed circuit board including a third surface facing the second surface and a fourth surface opposite to the third surface, and spaced apart from the first printed circuit board. The electronic device may include an interposer disposed between the first printed circuit board and the second printed circuit board to form a space between the first printed circuit board and the second printed circuit board. The electronic device may include a first electronic component disposed on the first surface. The electronic device may include a plurality of second electronic components disposed on the second surface and located within the space. The electronic device may include a thermal interface material (TIM) included within the space. The thermal interface material may be spaced apart from at least one electronic component of the plurality of second electronic components.

An electronic device is provided. The electronic device may include a display facing a first direction. The electronic device may include a housing including a first plate supporting the display, and a second plate facing a second direction opposite to the first direction. The electronic device may include a first printed circuit board disposed within the housing and including a first surface facing the first direction, and a second surface facing the second direction. The electronic device may include a second printed circuit board spaced apart from the first printed circuit board in the second direction and including a third surface facing the first direction and a fourth surface facing the second direction. The electronic device may include an interposer disposed between the first printed circuit board and the second printed circuit board to form a space between the first printed circuit board and the second printed circuit board. The electronic device may include a first electronic component disposed on the first surface. The electronic device may include a plurality of second electronic components disposed on the second surface and positioned within the space. The electronic device may include a thermal interface material (TIM) included within the space. The thermal interface material may include at least one of recesses or openings corresponding to the plurality of second electronic components so as to be spaced apart from the plurality of second electronic components.

### [Brief Description of Drawings]

FIG. 1 is a block diagram of an electronic device in a network environment according to various embodiments.
FIG. 2 illustrates an example electronic device.
FIG. 3 is an exploded perspective view of an example electronic device.
FIG. 4 illustrates a printed circuit board according to an embodiment.
FIG. 5 is a cross-sectional view of an example electronic device taken along line A-A' of FIG. 2.
FIG. 6 is a flowchart illustrating a manufacturing process of a printed circuit board according to an embodiment.
FIGS. 7A, 7B, and 7C illustrate a manufacturing process of a printed circuit board according to an embodiment.
FIG. 8 illustrates a manufacturing process of a printed circuit board according to an embodiment.
FIG. 9 illustrates a manufacturing process of a printed circuit board according to a comparative example.
FIG. 10A is a front view of a third surface of a second printed circuit board.
FIG. 10B schematically illustrates a printed circuit board including a thermal interface material in which an opening is formed.
FIG. 10C schematically illustrates a printed circuit board including a thermal interface material in which a recess is formed.
FIG. 11 illustrates a thermal interface material having a shape corresponding to outer surfaces of a plurality of second electronic components.
FIG. 12A illustrates a printed circuit board before a thermal interface material is disposed thereon.
FIG. 12B illustrates a printed circuit board on which a thermal interface material is coated.
FIG. 12C illustrates a printed circuit board after a bonding process is completed.
FIG. 13 illustrates a manufacturing process of a printed circuit board according to an embodiment.

### [Mode for Carrying out the Invention]

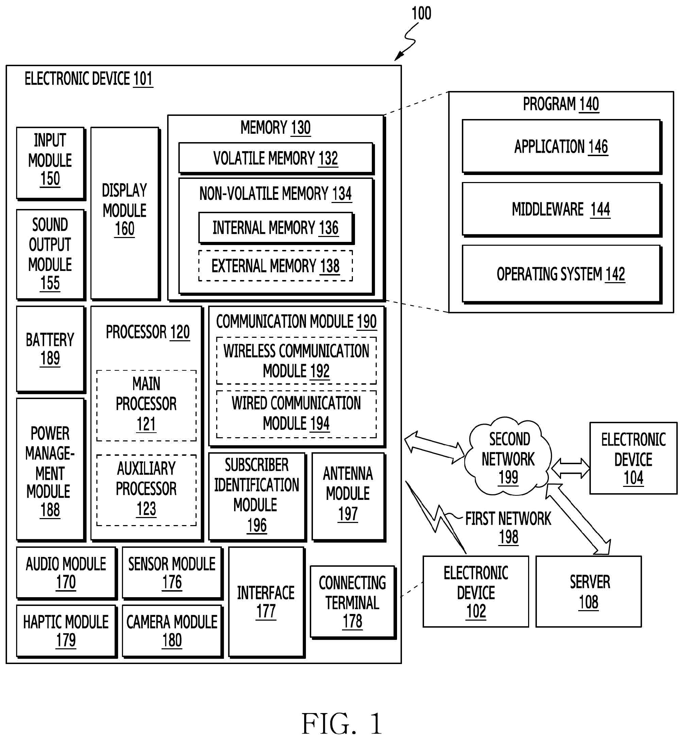

FIG. 1 is a block diagram of an electronic device in a network environment according to an embodiment.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In an embodiment, at least one of the components (e.g., the connecting terminal 178) may be omitted from the electronic device 101, or one or more other components may be added in the electronic device 101. In an embodiment, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may, for example, control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but the disclosure is not limited thereto. The artificial intelligence model may, additionally or alternatively, include a software structure other than the hardware structure.

The memory 130 may store various data used by at least one component (e.g., the processor 120 or the sensor module 176) of the electronic device 101. The data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or an external electronic device (e.g., the electronic device 102) (e.g., speaker or headphone) directly or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly or wirelessly. According to an embodiment, the interface 177 may include, for example, a high definition multimedia interface (HDMI), a universal serial bus (USB) interface, a secure digital (SD) card interface, or an audio interface.

The connecting terminal 178 may include a connector via which the electronic device 101 may be physically connected with the external electronic device (e.g., the electronic device 102). According to an embodiment, the connecting terminal 178 may include, for example, an HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the millimeter wave (mmWave) band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large-scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra-low-latency services using, e.g., distributed computing or mobile edge computing. In an embodiment, the external electronic device 104 may include an internetof-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or health care) based on 5G communication technology and IoT-related technology.

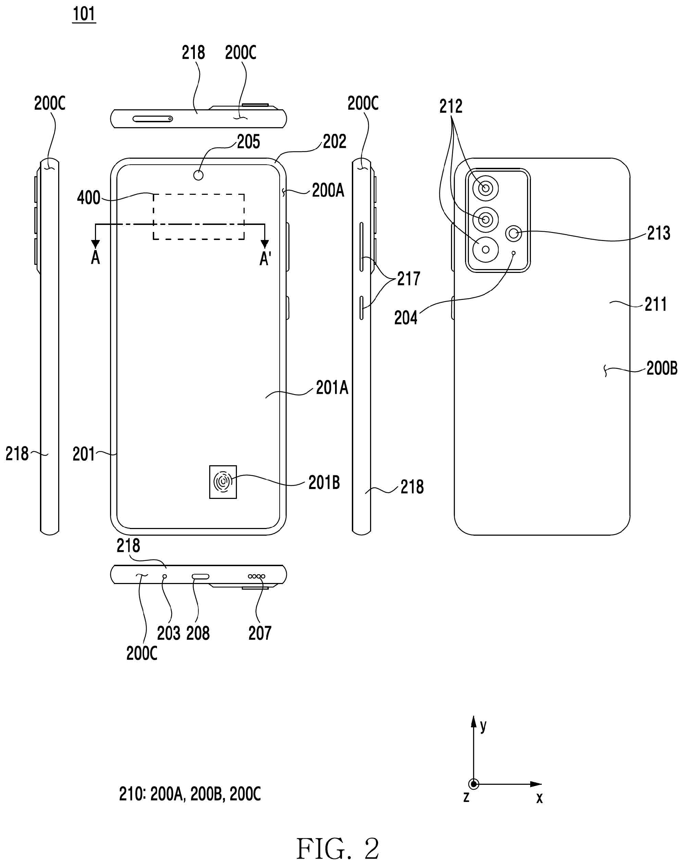

FIG. 2 illustrates an example electronic device.

Referring to FIG. 2, an electronic device 101 according to an embodiment may include a housing 210 forming an exterior of the electronic device 101. For example, the housing 210 may include a first surface (or a front surface) 200A, a second surface (or a back surface) 200B, and a third surface (or a side surface) 200C surrounding a space between the first surface 200A and the second surface 200B.

The electronic device 101 according to an embodiment may include a first plate 202 that is substantially transparent. According to an embodiment, the first plate 202 may form at least a portion of the first surface 200A. According to an embodiment, the first plate 202 may include, for example, a glass plate or a polymer plate including various coating layers, but is not limited thereto.

The electronic device 101 according to an embodiment may include a second plate 211 that is substantially opaque. According to an embodiment, the second plate 211 may form at least a portion of the second surface 200B. According to an embodiment, the second plate 211 may be formed of coated or colored glass, ceramic, polymer, metal (e.g., aluminum, stainless steel (STS), or magnesium), or a combination of at least two of the above materials.

The electronic device 101 according to an embodiment may include a side frame 218. According to an embodiment, the side frame 218 may be combined with the first plate 202 and/or the second plate 211 to form at least a portion of the third surface 200C of the electronic device 101. For example, the side frame 218 may form the entire third surface 200C of the electronic device 101. For example, the side frame 218 may form the third surface 200C of the electronic device 101 together with the first plate 202 and/or the second plate 211.

The electronic device 101 according to an embodiment may include at least one of a display 201, audio modules 203, 204, and 207, a sensor module (not shown), camera modules 205, 212, and 213, a key input device 217, a light emitting element (not shown), and/or a connector hole 208. According to an embodiment, the electronic device 101 may omit at least one of the components (e.g., the key input device 217 or the light emitting element (not shown)) or may further include other components.

According to an embodiment, at least a portion of the display 201 (e.g., the display module 160 of FIG. 1) may be visible through the first plate 202 forming the first surface 200A. According to an embodiment, the display 201 may be disposed on a rear surface of the first plate 202.

According to an embodiment, an outer shape of the display 201 may be formed to be substantially identical to an outer shape of the first plate 202 adjacent to the display 201. According to an embodiment, in order to expand an area where the display 201 is visually exposed, a gap between an outer edge of the display 201 and an outer edge of the first plate 202 may be formed to be substantially identical.

According to an embodiment, the display 201 (or the first surface 200A of the electronic device 101) may include a screen display area 201A. According to an embodiment, the display 201 may provide visual information to a user through the screen display area 201A. In the illustrated embodiment, when the first surface 200A is viewed from the front, the screen display area 201A is shown as being spaced apart from the outer edge of the first surface 200A and located inside the first surface 200A, but is not limited thereto. According to an embodiment, when the first surface 200A is viewed from the front, at least a portion of an edge of the screen display area 201A may substantially coincide with an edge of the first surface 200A (or the first plate 202).

According to an embodiment, the screen display area 201A may include a sensing area 201B configured to obtain biometric information of the user. Here, the meaning of "the screen display area 201A includes the sensing area 201B" may be understood as that at least a portion of the sensing area 201B may be overlapped with the screen display area 201A. For example, the sensing area 201B may display visual information by the display 201 as in other areas of the screen display area 201A, and may additionally mean an area capable of obtaining biometric information (e.g., a fingerprint) of the user. According to an embodiment, the sensing area 201B may be formed in the key input device 217.

According to an embodiment, the display 201 may include an area where a first camera module 205 (e.g., the camera module 180 of FIG. 1) is located. According to an embodiment, an opening is formed in the area of the display 201, and the first camera module 205 (e.g., a punch-hole camera) may be at least partially disposed within the opening to face the first surface 200A. In this case, the screen display area 201A may surround at least a portion of an edge of the opening. According to an embodiment, the first camera module 205 (e.g., an under-display camera (UDC)) may be disposed under the display 201 to overlap the area of the display 201. In such a case, the display 201 may provide visual information to the user through the area, and additionally, the first camera module 205 may obtain an image corresponding to a direction facing the first surface 200A through the area of the display 201.

According to an embodiment, the display 201 may be combined with or disposed adjacent to a touch sensing circuit, a pressure sensor capable of measuring an intensity (pressure) of a touch, and/or a digitizer detecting a magnetic field type stylus pen.

According to an embodiment, the audio modules 203, 204, and 207 (e.g., the audio module 170 of FIG. 1) may include microphone holes 203 and 204 and/or a speaker hole 207.

According to an embodiment, the microphone holes 203 and 204 may include a first microphone hole 203 formed in a partial area of the third surface 200C and/or a second microphone hole 204 formed in a partial area of the second surface 200B. A microphone (not shown) for obtaining external sound may be disposed inside the microphone holes 203 and 204. The microphone may include a plurality of microphones so as to detect a direction of sound.

According to an embodiment, the second microphone hole 204 formed in a partial area of the second surface 200B may be disposed adjacent to the camera modules 212 and 213. For example, the second microphone hole 204 may obtain sound according to an operation of the camera modules 212 and 213. However, the disclosure is not limited thereto.

According to an embodiment, the speaker hole 207 may include an external speaker hole 207 and a receiver hole for call (not shown). The external speaker hole 207 may be formed in a portion of the third surface 200C of the electronic device 101. According to an embodiment, the external speaker hole 207 and the microphone hole 203 may be implemented as a single hole. Although not shown, the receiver hole for call (not shown) may be formed in another portion of the third surface 200C. For example, the receiver hole for call may be formed on an opposite side of the external speaker hole 207 on the third surface 200C. For example, based on the illustration of FIG. 2, the external speaker hole 207 may be formed in the third surface 200C corresponding to a lower end of the electronic device 101, and the receiver hole for call may be formed in the third surface 200C corresponding to an upper end of the electronic device 101. However, the disclosure is not limited thereto, and according to an embodiment, the receiver hole for call may be formed at a position other than the third surface 200C. For example, the receiver hole for call may be formed by a space between the first plate 202 (or the display 201) and the side frame 218.

According to an embodiment, the electronic device 101 may include at least one speaker (not shown) configured to output sound to the outside of the housing 210 through the external speaker hole 207 and/or the receiver hole for call (not shown).

According to an embodiment, the sensor module (not shown) (e.g., the sensor module 176 of FIG. 1) may generate an electrical signal or a data value corresponding to an internal operating state of the electronic device 101 or an external environmental state. For example, the sensor module may include at least one of a proximity sensor, an HRM sensor, a fingerprint sensor, a gesture sensor, a gyro sensor, a barometric pressure sensor, a magnetic sensor, an acceleration sensor, a grip sensor, a color sensor, an infrared (IR) sensor, a biometric sensor, a temperature sensor, a humidity sensor, or an illuminance sensor.

According to an embodiment, the camera modules 205, 212, and 213 (e.g., the camera module 180 of FIG. 1) may include a first camera module 205 disposed to face the first surface 200A of the electronic device 101, a second camera module 212 disposed to face the second surface 200B, and a flash 213.

According to an embodiment, the second camera module 212 may include a plurality of cameras (e.g., a dual camera, a triple camera, or a quad camera). However, the second camera module 212 is not necessarily limited to including a plurality of cameras, and may include a single camera.

According to an embodiment, the first camera module 205 and the second camera module 212 may include one or a plurality of lenses, an image sensor, and/or an image signal processor.

According to an embodiment, the flash 213 may include, for example, a light emitting diode or a xenon lamp. According to an embodiment, two or more lenses (e.g., an infrared camera, a wide-angle lens, and a telephoto lens) and image sensors may be disposed on one surface of the electronic device 101.

According to an embodiment, the key input device 217 (e.g., the input module 150 of FIG. 1) may be disposed on the third surface 200C of the electronic device 101. According to an embodiment, the electronic device 101 may not include some or all of the key input devices 217, and the key input device 217 not included may be implemented in another form such as a soft key on the display 201.

According to an embodiment, the connector hole 208 may be formed in the third surface 200C of the electronic device 101 so that a connector of an external device can be accommodated therein. A connection terminal (e.g., the connection terminal 178 of FIG. 1) electrically connected to the connector of the external device may be disposed within the connector hole 208. The electronic device 101 according to an embodiment may include an interface module (e.g., the interface 177 of FIG. 1) for processing electrical signals transmitted and received through the connection terminal.

According to an embodiment, the electronic device 101 may include a light emitting element (not shown). For example, the light emitting element (not shown) may be disposed on the first surface 200A of the housing 210. The light emitting element (not shown) may provide status information of the electronic device 101 in the form of light. According to an embodiment, the light emitting element (not shown) may provide a light source in association with an operation of the first camera module 205. For example, the light emitting element (not shown) may include an LED, an IR LED, and/or a xenon lamp.

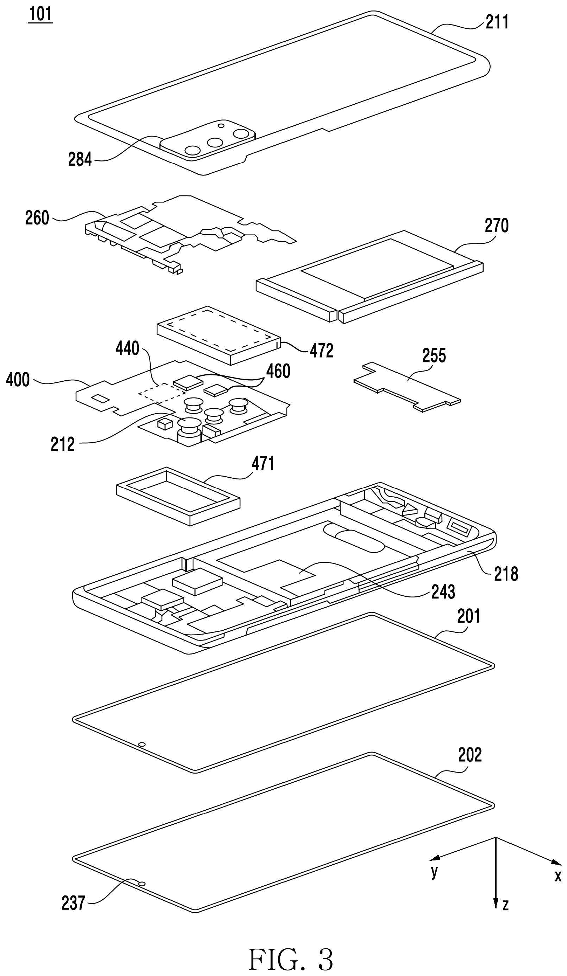

FIG. 3 is an exploded perspective view of an example electronic device.

Hereinafter, redundant descriptions of configurations having the same reference numerals as those described above will be omitted.

Referring to FIG. 3, an electronic device 101 according to an embodiment may include a display 201, a first plate 202, a second plate 211, a side frame 218, a support member 243, a printed circuit board 400, a sub-printed circuit board 255, a cover plate 260, a battery 270, and/or a shield can 320.

The electronic device 101 according to an embodiment may include the side frame 218 forming an exterior (e.g., the third surface 200C of FIG. 2) of the electronic device 101 and the support member 243 extending inward from the side frame 218. According to an embodiment, the side frame 218 and the support member 243 may be disposed between the display 201 and the second plate 211. For example, the side frame 218 may surround a space between the second plate 211 and the first plate 202 (and/or the display 201). For example, the support member 243 may extend from the side frame 218 within the space.

According to an embodiment, the support member 243 may support or accommodate other components included in the electronic device 101. For example, the display 201 may be disposed on one surface of the support member 243 facing one direction (e.g., +z direction), and the display 201 may be supported by the support member 243. For example, the printed circuit board 400, the battery 270, and the second camera module 212 may be disposed on the other surface facing a direction opposite to the direction (e.g., -z direction) of the support member 243. For example, the printed circuit board 400, the battery 270, and the second camera module 212 may be respectively seated in recesses defined by the side frame 218 and/or the support member 243.

According to an embodiment, the printed circuit board 400 and the battery 270 may be coupled to the support member 243, respectively. For example, the printed circuit board 400 may be fixedly disposed on the support member 243 through a coupling member such as a screw. For example, the battery 270 may be fixedly disposed on the support member 243 through an adhesive member (e.g., a double-sided tape). However, the disclosure is not limited by the above-described examples.

According to an embodiment, the cover plate 260 may be disposed between the printed circuit board 400 and the second plate 211. According to an embodiment, the cover plate 260 may be disposed on the printed circuit board 400. For example, the cover plate 260 may be disposed on a surface facing -z direction of the printed circuit board 400.

According to an embodiment, the cover plate 260 may at least partially overlap the printed circuit board 400 with respect to the z-axis. According to an embodiment, the cover plate 260 may cover at least a partial area of the printed circuit board 400. In this way, the cover plate 260 may protect the printed circuit board 400 from physical impact or prevent a connector coupled to the printed circuit board 400 from becoming detached.

According to an embodiment, the cover plate 260 may be fixedly disposed on the printed circuit board 400 through a coupling member (e.g., a screw), or may be coupled to the support member 243 together with the printed circuit board 400 through the coupling member.

According to an embodiment, the display 201 may be disposed between the support member 243 and the first plate 202. For example, the first plate 202 may be disposed on one side (e.g., +z direction) of the display 201, and the support member 243 may be disposed on the other side (e.g., -z direction).

According to an embodiment, the first plate 202 may be coupled to the display 201. For example, the first plate 202 and the display 201 may be attached to each other through an optical adhesive member (e.g., an optically clear adhesive (OCA) or an optically clear resin (OCR)) interposed therebetween.

According to an embodiment, the first plate 202 may be coupled to the side frame 218. For example, when viewed in the z-axis direction, the first plate 202 may include an outer portion extending out of the display 201, and may be attached to the side frame 218 through an adhesive member (e.g., a waterproof tape) disposed between the outer portion of the first plate 202 and the side frame 218. However, the disclosure is not limited by the above-described example.

According to an embodiment, a processor (e.g., the processor 120 of FIG. 1), memory (e.g., the memory 130 of FIG. 1), and/or an interface (e.g., the interface 177 of FIG. 1) may be disposed on the printed circuit board 400. The processor may include, for example, one or more of a central processing unit, an application processor, a graphics processing unit, an image signal processor, a sensor hub processor, or a communication processor. The memory may include, for example, a volatile memory or a non-volatile memory. The interface may include, for example, a high-definition multimedia interface (HDMI), a universal serial bus (USB) interface, an SD card interface, and/or an audio interface. The interface may electrically or physically connect the electronic device 101 with an external electronic device, and may include a USB connector, an SD card/MMC connector, or an audio connector. According to an embodiment, the electronic device 101 may include a sub-printed circuit board 255. The printed circuit board 400 and the sub-printed circuit board 255 may be operatively or electrically connected to each other via a connecting member (e.g., a flexible printed circuit board).

According to an embodiment, the battery 270 (e.g., the battery 189 of FIG. 1) may supply power to at least one component of the electronic device 101. For example, the battery 270 may include a rechargeable secondary battery or a fuel cell. At least a portion of the battery 270 may be disposed substantially coplanar with the printed circuit board 400 and/or the sub-printed circuit board 255.

The electronic device 101 according to an embodiment may include an antenna module (not shown) (e.g., the antenna module 197 of FIG. 1). According to an embodiment, the antenna module may be disposed between the second plate 211 and the battery 270. The antenna module may include, for example, a near field communication (NFC) antenna, a wireless charging antenna, and/or a magnetic secure transmission (MST) antenna. The antenna module may, for example, perform short-range communication with an external device or wirelessly transmit and receive power to and from the external device.

According to an embodiment, the first camera module 205 (e.g., a front camera) may be disposed on at least a portion of the support member 243 such that a lens can receive external light through a partial area (e.g., a camera area 237) of the first plate 202 (e.g., the front surface 200A of FIG. 2).

According to an embodiment, the second camera module 212 (e.g., a rear camera) may be disposed between the support member 243 and the second plate 211. According to an embodiment, the second camera module 212 may be electrically connected to the printed circuit board 400 via a connecting member (e.g., a connector). According to an embodiment, the second camera module 212 may be disposed such that a lens can receive external light through a camera area 284 of the second plate 211 of the electronic device 101.

According to an embodiment, the camera area 284 may be formed on a surface of the second plate 211 (e.g., the back surface 200B of FIG. 2). According to an embodiment, the camera area 284 may be formed to be at least partially transparent so that external light can be incident to the lens of the second camera module 212. According to an embodiment, at least a portion of the camera area 284 may protrude to a predetermined height from the surface of the second plate 211. However, the disclosure is not limited thereto, and according to an embodiment, the camera area 284 may form substantially the same plane as the surface of the second plate 211.

According to an embodiment, the housing 210 of the electronic device 101 may mean a configuration or structure forming at least a portion of the exterior of the electronic device 101. In this regard, at least a portion of the first plate 202, the side frame 218, and/or the second plate 211 forming the exterior of the electronic device 101 may be referred to as the housing 210 of the electronic device 101.

The electronic device 101 according to an embodiment may include electronic components for implementing various functions of the electronic device 101. For example, the electronic device 101 may include a first electronic component 440 disposed on the printed circuit board 400. For example, the first electronic component 440 may include an application processor (AP) for controlling overall operations of the electronic device 101, but is not limited thereto.

According to an embodiment, the printed circuit board 400 may be a stack-type substrate. The printed circuit board 400 may include a first printed circuit board 410, a second printed circuit board 420, and an interposer 430. A plurality of second electronic components 450 may be located within an internal space formed by the first printed circuit board 410, the second printed circuit board 420, and the interposer 430. For example, the first electronic component 440 may be exposed to the outside of the printed circuit board 400, and the plurality of second electronic components 450 may be located inside the printed circuit board 400. The first electronic component 440 may be disposed on a surface of the printed circuit board 400 facing the display 201. The electronic device 101 may include a first shield can 471 for covering the first electronic component 440. According to an embodiment, the first shield can 471 may include an opening 471a facing the AP.

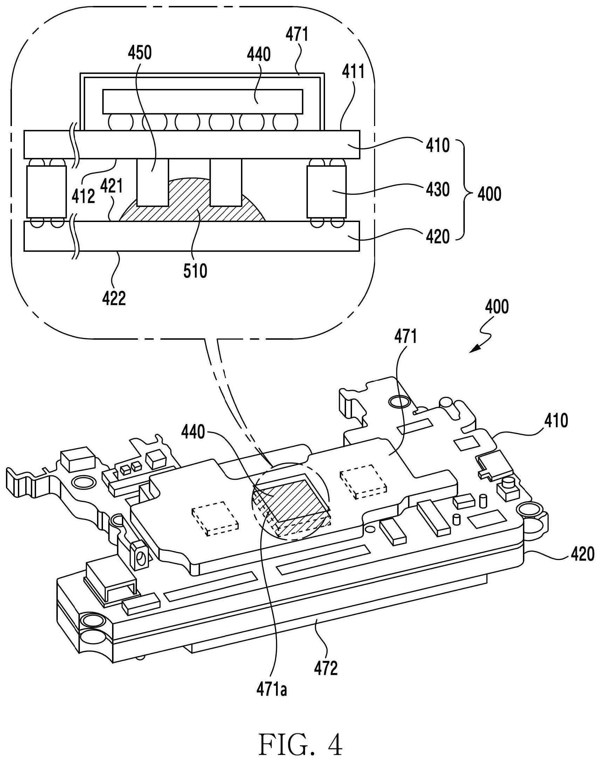

The electronic device 101 according to an embodiment may include a thermal interface material (e.g., a thermal interface material 510 of FIG. 4) (TIM). For example, the thermal interface material 510 may include a polymer composite material, a thermally conductive filler, and a dispersant. The thermally conductive filler may be referred to as heat dissipating particles. For example, the thermally conductive filler may include at least one of aluminum oxide (Al₂O₃), aluminum nitride (AlN), magnesium oxide (MgO), or boron nitride (BN).

According to an embodiment, the thermal interface material 510 may include a phase change material (PCM). For example, the phase change material may include, but is not limited to, paraffin, salt hydrate, and/or a polylactic acid (PLA)-based composite. For example, the thermal interface material 510 may include, but is not limited to, a matrix including rubber, and a phase change material. At a glass transition temperature, a phase of the phase change material may change.

The thermal interface material 510 may suppress an increase in the internal temperature of the electronic device 101 by diffusing heat. As the number of electronic components integrated into the printed circuit board 400 increases to implement various functions of the electronic device 101, more heat may be generated. For example, heat generated from the first electronic component 440 disposed to face the display 201 may be conducted toward the display 201. The heat may cause an increase in the temperature of the first electronic component 440, and the first electronic component 440 may limit performance of the display 201 to reduce damage caused by the temperature increase. For example, the first electronic component 440 may reduce the heat generation by lowering a clock and a voltage through throttling. According to an embodiment, as the thermal interface material 510 is included within the internal space of the stack-type substrate, a portion of the heat generated from the first electronic component 440 may be conducted toward the second plate 211. As the heat generated from the first electronic component 440 is conducted in different directions, an increase in the temperature of the electronic device 101 may be reduced, and performance degradation of the display 201 may be reduced. The electronic device 101 according to an embodiment may have a structure for effectively transferring the heat generated from the first electronic component 440 toward the second plate 211. Hereinafter, the electronic device 101 according to an embodiment will be described.

FIG. 4 illustrates a printed circuit board according to an embodiment.

Referring to FIG. 4, the printed circuit board 400 according to an embodiment may provide electrical connections of electronic components of the electronic device 101. For example, the printed circuit board 400 may include a plurality of conductive layers and a plurality of non-conductive layers alternately laminated with the plurality of conductive layers. For example, the printed circuit board 400 may provide electrical connections for electronic components using wiring and conductive vias formed in the conductive layers.

According to an embodiment, the printed circuit board 400 may be referred to as a stack-type substrate in which a plurality of printed circuit boards 400 are stacked. For example, the printed circuit board 400 may be referred to as a circuit board assembly in which a plurality of printed circuit boards 400 are stacked.

According to an embodiment, the printed circuit board 400 may include a first printed circuit board 410, a second printed circuit board 420, and an interposer 430.

According to an embodiment, the second printed circuit board 420 may be spaced apart from the first printed circuit board 410. For example, a gap between the first printed circuit board 410 and the second printed circuit board 420 may be about 0.7 mm to about 0.9 mm, but is not limited thereto. The interposer 430 may be disposed between the first printed circuit board 410 and the second printed circuit board 420. For example, the interposer 430 may be disposed along edges between the first printed circuit board 410 and the second printed circuit board 420. The interposer 430 may be connected between the first printed circuit board 410 and the second printed circuit board 420. The interposer 430 may provide an electrical connection between the first printed circuit board 410 and the second printed circuit board 420. The interposer 430 may provide an electromagnetic shielding function for electronic components disposed between the first printed circuit board 410 and the second printed circuit board 420. For example, the interposer 430 may include a conductive material for shielding electromagnetic waves emitted from other electronic components of the electronic device 101, thereby shielding electromagnetic noise transferred to the electronic components disposed between the first printed circuit board 410 and the second printed circuit board 420.

A space may be formed surrounded by the first printed circuit board 410, the second printed circuit board 420, and the interposer 430. The space may be referred to as an internal space of the printed circuit board 400. The printed circuit board 400, which has a structure in which a first printed circuit board 410 and a second printed circuit board 420 are stacked, may achieve a high degree of integration since various electronic components may be disposed thereon.

According to an embodiment, a first electronic component 440 and a first shield can 471 may be disposed on the first printed circuit board 410. For example, the first electronic component 440 may include an application processor (AP) for controlling overall operations of the electronic device 101, but is not limited thereto. For example, the AP may include a central processing unit (CPU) and/or a graphics processing unit (GPU). Transistors integrated within the CPU and/or the GPU perform various operations, and thus the AP may generate a relatively large amount of heat.

According to an embodiment, a plurality of second electronic components 450 may be disposed within the space formed by the first printed circuit board 410, the second printed circuit board 420, and the interposer 430. For example, the plurality of second electronic components 450 may be disposed on a second surface 412 of the first printed circuit board 410. For example, the plurality of second electronic components 450 may include a plurality of components. The plurality of second electronic components 450 may include a power-related IC (e.g., a power management integrated circuit (PMIC)) and passive elements (e.g., resistors, inductors, capacitors).

According to an embodiment, a thermal interface material 510 may be included within the space. As the thermal interface material 510 fills at least a portion of the space, heat generated from the first electronic component 440 and/or the plurality of second electronic components 450 may be diffused through the thermal interface material 510. The thermal interface material 510 may be disposed within the space in a manufacturing process of the printed circuit board 400.

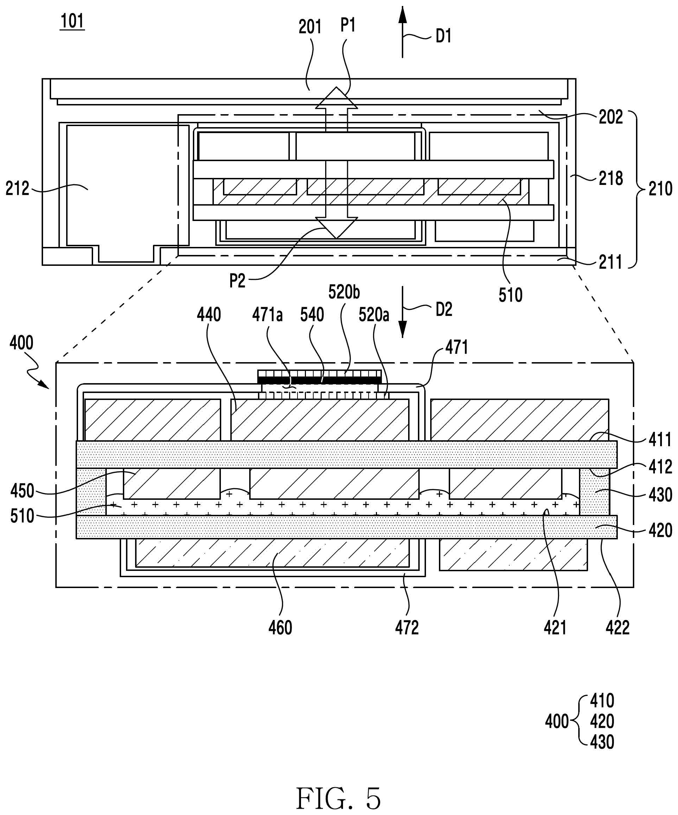

According to an embodiment, a third electronic component (e.g., a third electronic component 460 of FIG. 5) and a second shield can 472 may be disposed on the second printed circuit board 420. For example, the third electronic component 460 may include a radio frequency (RF) module (e.g., an RF transceiver). The second shield can 472 may cover the third electronic component 460 to shield electromagnetic waves generated when the third electronic component 460 operates. For example, the second shield can 472 may cover the third electronic component 460 so as to prevent electromagnetic waves emitted from the third electronic component 460 from affecting other electronic components, or to prevent electromagnetic waves emitted from other electronic components from affecting the third electronic component 460. Since the third electronic component 460 is covered by the second shield can 472, interference due to the electromagnetic waves may be reduced.

Hereinafter, a structure for disposing the thermal interface material 510 in the internal space of the printed circuit board 400 will be described with reference to the internal structure of the printed circuit board 400 and the structure of the housing 210 of the electronic device 101.

FIG. 5 is a cross-sectional view of an example electronic device taken along line A-A' of FIG. 2.

Referring to FIG. 5, the electronic device 101 may include a display 201 and a housing 210.

According to an embodiment, the display 201 may be configured to display visual information. The display 201 may form at least a portion of a front surface of the electronic device 101 so as to display visual information by controlling pixels and to transfer the displayed visual information to a user. For example, a portion of the front surface of the electronic device 101 may be formed by the display 201. The display 201 may be disposed to face the outside of the electronic device 101. In the present disclosure, a direction in which the display 201 faces may be referred to as a first direction, and a direction opposite to the first direction may be referred to as a second direction.

According to an embodiment, the housing 210 may form at least a portion of the exterior of the electronic device 101. For example, the housing 210 may include a first plate 202, a second plate 211, and a side frame 218. At least a portion of the first plate 202 may support the display 201. The first plate 202 may face the first direction. Facing the first direction by the first plate 202 may refer to a direction in which an outer surface of the first plate 202 faces substantially corresponding to the first direction. The first plate 202 may be referred to as a front plate or a front cover in that it forms a front surface of the housing 210. The second plate 211 may form at least a portion of a back surface of the electronic device 101. The second plate 211 may form at least a portion of a back surface of the electronic device 101. For example, at least a portion of the second plate 211 may be opposite to the display 201 forming at least a portion of the front surface of the electronic device 101. The second plate 211 may face the second direction. Facing the second direction by the second plate 211 may refer to a direction in which an outer surface of the second plate 211 faces substantially corresponding to the second direction. The second plate 211 may be referred to as a back plate or a back cover in that it forms the back surface of the housing 210. The side frame 218 may be disposed between the first plate 202 and the second plate 211, thereby forming an internal space of the housing 210. The side frame 218 may be formed integrally with the first plate 202 and/or the second plate 211.

According to an embodiment, components of the electronic device 101 may be disposed inside the housing 210. For example, the camera, the printed circuit board 400, the first electronic component 440, the plurality of second electronic components 450, and/or the third electronic component 460 may be disposed inside the housing 210.

According to an embodiment, the printed circuit board 400 is a stack-type substrate and may include the first printed circuit board 410, the second printed circuit board 420, and the interposer 430. According to an embodiment, the first printed circuit board 410 may include a first surface 411 and a second surface 412. For example, the first surface 411 may be a surface of the first printed circuit board 410 facing the first direction. For example, the second surface 412 may be a surface of the first printed circuit board 410 facing the second direction. The second surface 412 may be opposite to the first surface 411. The first electronic component 440 may be disposed on the first surface 411 to be electrically connected to the first printed circuit board 410. The plurality of second electronic components 450 may be disposed on the second surface 412 to be electrically connected to the first printed circuit board 410. The plurality of second electronic components 450 may be located within the space between the first printed circuit board 410 and the second printed circuit board 420. For example, the first electronic component 440 may include at least one of an AP, a universal flash storage (UFS), or a socket, but is not limited thereto. For example, the plurality of second electronic components 450 may include passive elements, but are not limited thereto.

According to an embodiment, the second printed circuit board 420 may be spaced apart from the first printed circuit board 410 in the second direction. The second printed circuit board 420 may be electrically connected to the first printed circuit board 410 through the interposer 430. A height of the interposer 430 may be about 0.8 mm, but is not limited thereto.

According to an embodiment, the second printed circuit board 420 may include a third surface 421 and a fourth surface 422. For example, the third surface 421 may be a surface of the second printed circuit board 420 facing the first direction. For example, the fourth surface 422 may be a surface of the second printed circuit board 420 facing the second direction. The fourth surface 422 may be opposite to the third surface 421. The third electronic component 460 may be disposed on the fourth surface 422 to be electrically connected to the second printed circuit board 420. For example, the third electronic component 460 may include at least one of an RF module or a connector, but is not limited thereto.

According to an embodiment, a first shield can 471 may be disposed on the first surface 411 of the first printed circuit board 410. The first shield can 471 may cover at least a portion of the first electronic component 440 disposed on the first surface 411. According to an embodiment, the first shield can 471 may include an opening 471a facing the AP. For example, when the first shield can 471 is viewed from above, the opening 471a and the first electronic component 440 may at least partially overlap. The opening 471a may provide a path (e.g., a first heat transfer path) through which heat generated from the first electronic component 440 is discharged to the outside of the first shield can 471. In a case where the first shield can 471 does not include the opening 471a, the heat generated from the first electronic component 440 may not be discharged to the outside of the first shield can 471 and may remain inside the first shield can 471. In a case where the heat remains inside the first shield can 471, a temperature increase of the first electronic component 440 may be caused. The opening 471a may provide the first heat transfer path so that the heat generated from the first electronic component 440 may be transferred substantially through the first direction. Another thermal interface material 520a may be disposed on an upper surface of the AP so that the heat generated from the first electronic component 440 may be transferred. In order to block electromagnetic waves, a shield sheet 540 covering the opening 471a may be disposed. A thermal interface material 520b may be further disposed between the shield sheet 540 and the first plate 201.

In a case where the heat generated from the first electronic component 440 (e.g., the AP) is transferred along the first heat transfer path facing the first direction, a temperature increase of the display 201 located in the first direction with respect to the first electronic component 440 may be caused. In order to reduce damage due to the temperature increase, a clock of the GPU may be reduced. For example, in a case where the temperature of the display 201 exceeds a threshold temperature, the clock of the GPU is reduced, whereby quality of visual information displayed on the display 201 may deteriorate.

According to an embodiment, as a thermal interface material 510 is included within the space between the first printed circuit board 410 and the second printed circuit board 420, a second heat transfer path through which heat generated from the first electronic component 440 (e.g., an AP) is transferred in the second direction may be formed. For example, since the first electronic component 440 is in contact with the first printed circuit board 410, the heat generated from the first electronic component 440 may be transferred to the first printed circuit board 410. As the thermal interface material 510 included within the space comes into contact with the first printed circuit board 410, the heat may be transferred in the second direction by the thermal interface material 510. According to an embodiment, the thermal interface material 510 may form the second heat transfer path through which the heat generated from the first electronic component 440 is transferred in the second direction. According to an embodiment, since the heat generated from the first electronic component 440 may be diffused along the first heat transfer path and the second heat transfer path, the heat may be relatively evenly diffused without being concentrated in a specific area. According to an embodiment, a heat dissipation effect of the first electronic component 440 may be enhanced, and performance degradation of the first electronic component 440 (e.g., the AP) may be reduced. For example, when the first electronic component 440 operates, a time for the temperature of the display 201 to reach the threshold temperature is delayed, whereby improved performance of the display 201 may be achieved.

According to an embodiment, the thermal interface material 510 may include a phase change material. The thermal interface material 510 including the phase change material may be disposed in a solid phase state in a process of manufacturing the printed circuit board 400. For example, after the solid-phase thermal interface material 510 is disposed on the second printed circuit board 420, a hot press process may be performed. In order for a phase change of the phase change material included in the thermal interface material 510 to occur, the hot press process may be performed at a temperature equal to or higher than a glass transition temperature of the phase change material. Through the hot press process, the phase change material included in the thermal interface material 510 may be changed into a semi-solid or quasi-solid phase (e.g., a gel). As the phase change material is changed into the semi-solid phase having fluidity, at least a portion of the thermal interface material 510 may diffuse into the internal space of the printed circuit board 400.

According to an embodiment, the phase change material may absorb enthalpy of fusion when the phase is changed from a solid phase to a liquid phase or a semi-solid phase. When heat is generated from the first electronic component 440 and/or the plurality of second electronic components 450, the phase change material may reach a melting point by absorbing the heat. The phase change material may absorb thermal energy corresponding to the enthalpy of fusion by undergoing a phase change at its melting point. As the phase change material absorbs heat generated from the first electronic component 440 and/or the plurality of second electronic components 450, a heat dissipation effect may be enhanced. In terms of including the phase change material, the thermal interface material 510 may be referred to as a thermally responsive thermal interface material.

According to an embodiment, the thermal interface material 510 may be disposed in the space inside the printed circuit board 400 in a surface mount technology (SMT) process of the printed circuit board 400. For example, in a case where a nozzle is inserted into the second printed circuit board 420 to inject the thermal interface material 510, openings (e.g., injection holes, inspection holes) for injection of the thermal interface material 510 and members (e.g., sealing members, films) for reducing leakage of the thermal interface material 510 during injection may be required. Since a separate process is required to form the openings, the manufacturing process of the printed circuit board 400 may become more complicated, and its manufacturing time may increase. An internal mounting space inside the electronic device 101 for disposing the members may be insufficient. In a case where the thermal interface material 510 includes a phase change material, a particle size of the phase change material must be smaller than gaps between the plurality of second electronic components 450, and therefore, it may be difficult to design the thermal interface material 510 to overlap with the plurality of second electronic components 450. Due to a difference in thickness of the plurality of second electronic components 450 or warping of the printed circuit board 400, a contact area between the phase change material and the plurality of second electronic components 450 may be reduced, whereby the heat transfer effect may be reduced. In a case where a pad-type solid-phase thermal interface material 510 is utilized, it may be difficult to attach the thermal interface material 510 onto the printed circuit board 400, and a temperature of a bonding process of the printed circuit board 400 must be lower than a vaporization temperature (e.g., about 120 °C) of the phase change material; therefore, when the bonding process is performed at a conventional soldering temperature (e.g., about 200 °C to about 250 °C), a problem may be caused in that the phase change material is vaporized.

According to an embodiment, the printed circuit board 400 may be manufactured by disposing the thermal interface material 510 during the bonding process of the printed circuit board 400 and diffusing the thermal interface material 510 into the internal space of the printed circuit board 400, using the phase change at a reflow process temperature. When the first printed circuit board 410 is bonded to the second printed circuit board 420, the heat dissipation effect may be enhanced by using weight of the first electronic component 440 to press down the thermal interface material 510 overlapping within the space, and diffusing the thermal interface material 510 in the reflow process. Hereinafter, the manufacturing process of the printed circuit board 400 will be described.

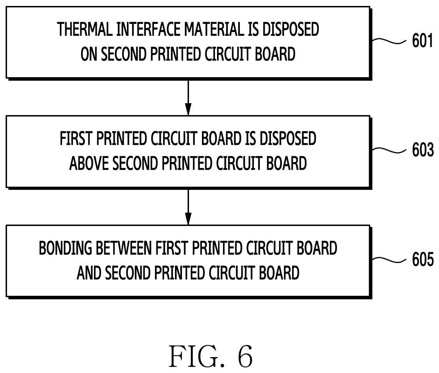

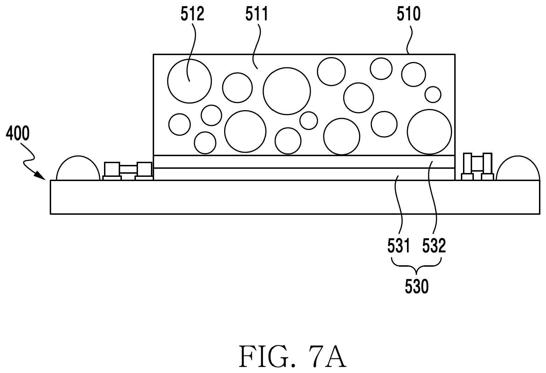

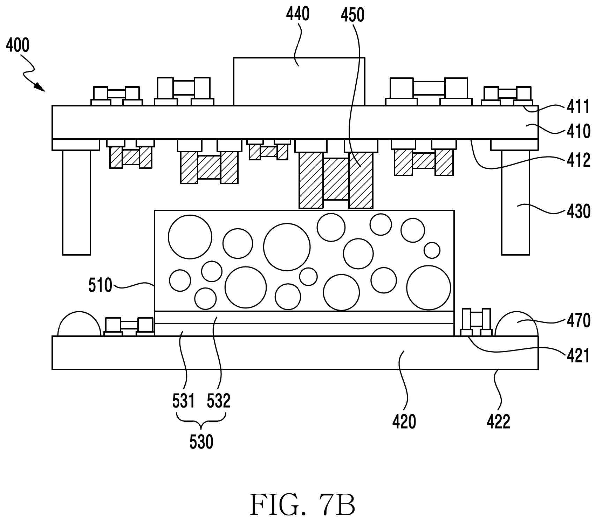

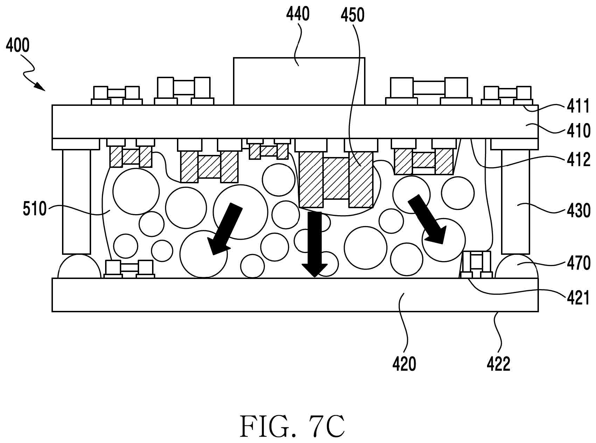

FIG. 6 is a flowchart illustrating a manufacturing process of a printed circuit board according to an embodiment. FIGS. 7A, 7B, and 7C illustrate a manufacturing process of a printed circuit board according to an embodiment.

Referring to FIG. 6, in operation 601, the thermal interface material 510 may be disposed on the second printed circuit board 420.

Referring to FIG. 7A, the thermal interface material 510 may be placed on the third surface 421 of the second printed circuit board 420. For example, the thermal interface material 510 may be picked up by pickup equipment and disposed on the third surface 421. The thermal interface material 510 is a pad type and may be in a solid phase before the bonding process.

According to an embodiment, the pickup equipment may place the thermal interface material 510 on the third surface 421 of the second printed circuit board 420 by moving the thermal interface material 510 in its adsorbed or mounted state. The thermal interface material 510 may be rigid enough to be picked up by the pickup equipment. In a case where the thermal interface material 510 is soft, it is difficult to be moved by the pickup equipment, and thus warping or damage may be caused. The thermal interface material 510 may be manufactured by a molten casting method of polymer paraffin wax. For example, a liquid-phase or semi-solid-phase thermal interface material 510 may have a certain shape through a mold, and may be moved by the pickup equipment, after being cured. The thermal interface material 510 may have rigidity through the molten casting and thus be disposed on the third surface 421 of the second printed circuit board 420.

According to an embodiment, the thermal interface material 510 may be attached to at least one adhesive layer 530 attached on the third surface 421. For example, the at least one adhesive layer 530 may include a first adhesive layer 531 and a second adhesive layer 532. The first adhesive layer 531 may be attached on the third surface 421, and the second adhesive layer 532 may be interposed between the first adhesive layer 531 and the thermal interface material 510. For example, when the thermal interface material 510 is disposed on the third surface 421, the first adhesive layer 531 may reduce distortion of the thermal interface material 510 and fix the thermal interface material 510 so as to not move during the bonding process. For example, the first adhesive layer 531 may include acryl, but is not limited thereto. For example, the second adhesive layer 532 may be attached to each of the thermal interface material 510 and the first adhesive layer 531, thereby fixing the thermal interface material 510 on the first adhesive layer 531. For example, the second adhesive layer 532 may be referred to as a hot melt layer. As described later, in the bonding process, the second adhesive layer 532 may be vaporized.

According to an embodiment, the thermal interface material 510 may include a matrix 511 including rubber and a thermally conductive filler 512. For example, the thermal interface material 510 may include about 80 wt% of the thermally conductive filler 512, about 12 wt% of the matrix 511 including rubber, about 4 wt% of a phase change material, and about 4 wt% of an additive, but the present disclosure is not limited thereto. For example, a pure phase change material may cause a rapid weight change and vaporization due to a one-step phase change. Since the thermal interface material 510 includes the matrix 511 including rubber, a sequential weight change and vaporization may be caused by an attractive force between the rubber and the phase change material. For example, when the phase change material undergoes a phase change, a two-step phase change may be caused, thereby reducing a rapid change in physical properties. For example, the rubber may include styrene ethylene butylene styrene (SEBS). The chemical formula of the SEBS may be [CH₂=CH(CH₃)]ₙ-[CH₂-CH(CH₃)-CH₂]ₘ-[CH₂=CH(CH₃)]ₙ, and the chemical formula of the phase change material may be C₁₆H₃₄ (hexadecane). Styrene ([CH₂=CH(CH₃)]ₙ) included in SEBS is a rigid domain and may provide stability of a semi-solid phase of thermal interface material 510. Ethylene and butylene ([CH₂-CH(CH₃)-CH₂]ₘ-[CH₂=CH(CH₃)]ₙ) included in SEBS are soft domains and have a chemical structure similar to that of the thermal interface material 510, and thus may provide an attractive force between the thermal interface material 510 and SEBS.

In operation 603, the first printed circuit board 410 may be disposed above the second printed circuit board 420.

Referring to FIG. 7B, the first printed circuit board 410 may be disposed above the second printed circuit board 420. The first electronic component 440 may be disposed on the first surface 411 of the first printed circuit board 410. Since the first electronic component 440 has a relatively large size, it may cause an increase in weight of the first printed circuit board 410. The interposer 430 may be coupled to the second surface 412 of the first printed circuit board 410. Solder paste 470 for bonding the interposer 430 may be disposed on the third surface 421 of the second printed circuit board 420.

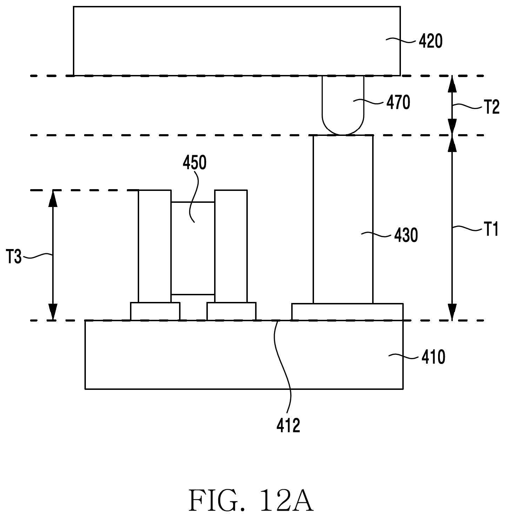

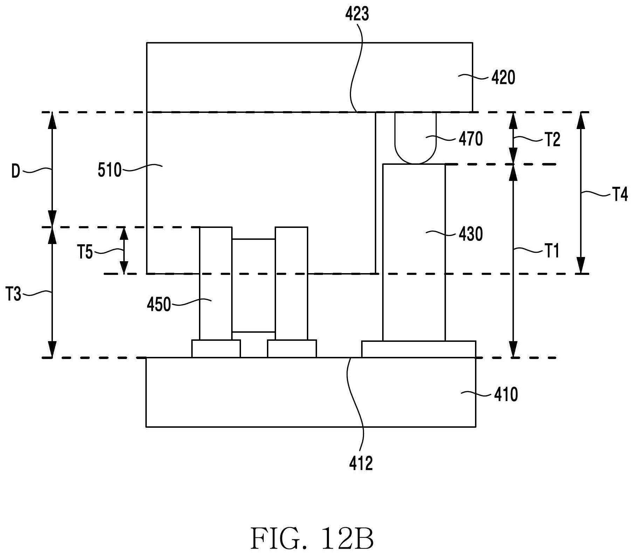

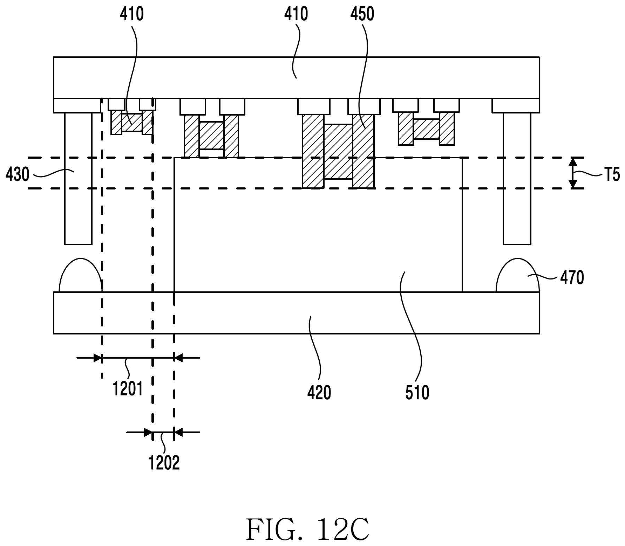

According to an embodiment, a plurality of second electronic components 450 may be disposed on the second surface 412. When the first printed circuit board 410 is disposed above the second printed circuit board 420, the plurality of second electronic components 450 may protrude from the second surface 412 toward the third surface 421. According to an embodiment, the thermal interface material 510 may overlap with at least one of the plurality of second electronic components 450. The overlapping structure will be described later with reference to FIGS. 12A, 12B, and 12C.

In operation 605, bonding between the first printed circuit board 410 and the second printed circuit board 420 may be performed.

Referring to FIG. 7C, by soldering bonding, the interposer 430 is bonded to the solder paste 470, and thus the first printed circuit board 410 and the second printed circuit board 420 may be bonded. A reflow process for bonding may be performed. In the reflow process, high-temperature thermal energy is provided, and thus the first printed circuit board 410 and the second printed circuit board 420 may be bonded. The reflow process may include a preheating operation in which the printed circuit board 400 is preheated in an oven, a temperature rising operation in which the printed circuit board 400 is heated to a melting temperature of the solder paste 470 after the preheating, a melting operation in which the first printed circuit board 410 and the second printed circuit board 420 are bonded by melting of the solder paste 470 at the melting temperature of the solder paste 470, and a cooling operation in which the solder paste 470 is solidified, but the present disclosure is not limited thereto. For example, the preheating operation may be performed at about 100 °C to about 150 °C, and the temperature rising operation may be performed at about 170 °C to about 240 °C. Since the temperature is higher than a glass transition temperature of the phase change material, the phase change material included in the thermal interface material 510 may undergo a phase change from a solid phase to a semi-solid phase or a liquid phase. The semi-solid phase or liquid phase of thermal interface material 510 may penetrate into spaces between the plurality of second electronic components 450, thereby coming into contact with the plurality of second electronic components 450.

As described above, since the thermal interface material 510 overlaps at least one of the plurality of second electronic components 450, it may be pressed by the plurality of second electronic components 450. Since the first electronic component 440 is disposed on the first surface 411 of the first printed circuit board 410, the plurality of second electronic components 450 may press the semi-solid phase or liquid phase of thermal interface material 510 by the weight of the first printed circuit board 410. By the pressing, the thermal interface material 510 may spread between the plurality of second electronic components 450. Since the weight of the first printed circuit board 410 may be increased by the first electronic component 440, a separate member (e.g., a weight, a jig) for pressing the thermal interface material 510 may not be required.

According to an embodiment, the size of the first printed circuit board 410 on which the first electronic component 440 is disposed may be smaller than the size of the second printed circuit board 420. The bonding process of the printed circuit board 400 is a process of bonding a sub-board (or a secondary board) to a main board (or a master board), wherein the first printed circuit board 410 on which the first electronic component 440 is disposed may be referred to as the sub-board, and the second printed circuit board 420 may be referred to as the main board. In a case where the first electronic component 440 is disposed on the main board, the separate member for pressing the thermal interface material 510 may be required. According to an embodiment, the weight of the first electronic component 440 may cause a relatively small increase in the weight of the first printed circuit board 410, which may simplify the manufacturing equipment and process for the printed circuit board 400.

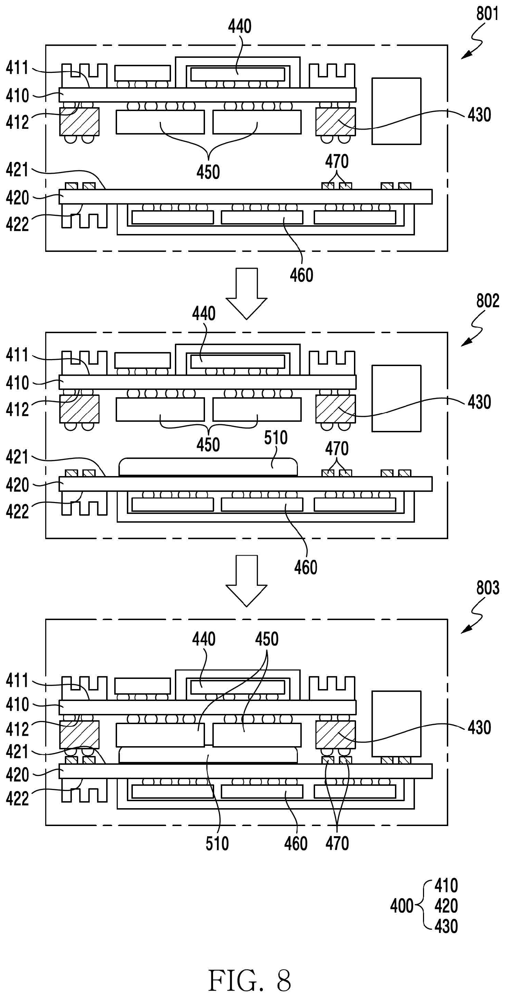

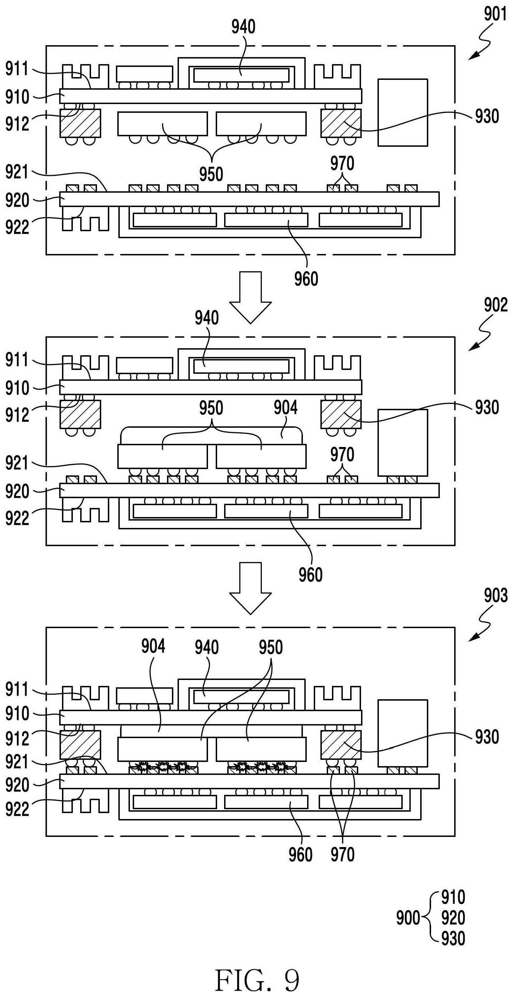

FIG. 8 illustrates a manufacturing process of a printed circuit board according to an embodiment. FIG. 9 illustrates a manufacturing process of a printed circuit board according to a comparative example.

FIGS. 8 and 9 illustrate a two-sided mounting structure or a three-sided mounting structure in which electronic components are arranged on the first surface 411, the second surface 412, and/or the fourth surface 422. The process shown in FIG. 8 may be substantially the same as the processes shown in FIGS. 7A, 7B, and 7C.

A first state 801 of FIG. 8 illustrates a state of the printed circuit board 400 according to an embodiment before the thermal interface material 510 is disposed. Referring to FIG. 8, in the printed circuit board 400 according to an embodiment, the first electronic component 440 may be disposed on the first surface 411 of the first printed circuit board 410 having a relatively small size. A plurality of second electronic components 450 may be disposed on the second surface 412 of the first printed circuit board 410 for electrical connection with the first printed circuit board 410 through the first printed circuit board 410. The third electronic component 460 may be disposed on the fourth surface 422 of the second printed circuit board 420 having a relatively large size. The third electronic component 460 may be omitted. In the case of a two-sided mounting structure, no electronic component may be disposed on the third surface 421.

A second state 802 of FIG. 8 illustrates a state of the printed circuit board 400 according to an embodiment in which the thermal interface material 510 is disposed. A solid-phase thermal interface material 510 may be disposed on the third surface 421 of the second printed circuit board 420. The thermal interface material 510 may be disposed on an area of the third surface 421 facing the plurality of second electronic components 450, so as to come into contact with the plurality of second electronic components 450. As described above, the thermal interface material 510 may include a matrix including rubber and a phase change material. Since no electronic components are disposed on the third surface 421, the solder paste 470 for electrical connection of electronic components may not be disposed on the area of the third surface 421 facing the plurality of second electronic components 450.

A third state 803 of FIG. 8 illustrates a state of the printed circuit board 400 according to an embodiment after a bonding process is performed. As the bonding process is performed, the solder paste 470 melts, whereby the interposer 430 and the second printed circuit board 420 may be bonded. The thermal interface material 510 may penetrate between the plurality of second electronic components 450 by changing the phase from a solid phase to a semi-solid phase or a liquid phase. The plurality of second electronic components 450 may press the thermal interface material 510. When the thermal interface material 510 is pressed, since the solder paste 470 does not exist under the thermal interface material 510, a situation in which the solder paste 470 is pressed may not occur.

Referring to FIG. 9, in a printed circuit board 900 according to a comparative example, a first electronic component 940 may be disposed on a second printed circuit board 920 having a relatively large size.

A first state 901 of FIG. 9 illustrates a state of the printed circuit board 900 according to the comparative example before a thermal interface material 904 is disposed. Referring to FIG. 9, in the printed circuit board 900 according to the comparative example, the first electronic component 940 may be disposed on a fourth surface 922 of the second printed circuit board 920 having a relatively large size. For electrical connection with the first printed circuit board 910 through the printed circuit board 900, a plurality of second electronic components 950 may be connected to a third surface 921 of the second printed circuit board 920. A third electronic component 960 may be disposed on a first surface 911 of the first printed circuit board 910 having a relatively small size. In the case of a two-sided mounting structure, the third electronic component 960 may be omitted.

A second state 902 of FIG. 9 illustrates a state of the printed circuit board 900 according to the comparative example in which the thermal interface material 904 is disposed. The plurality of second electronic components 950 may be connected on a second surface 912. The second printed circuit board 920 may include a solder paste 970 corresponding to the plurality of second electronic components 950 for electrical connection with the plurality of second electronic components 950. The solder paste 970 may be disposed on the third surface 921. The solid-phase thermal interface material 904 may be disposed over the plurality of second electronic components 950 disposed on the third surface 921.

A third state 903 of FIG. 9 illustrates a state of the printed circuit board 900 according to the comparative example after the bonding process is performed. The first printed circuit board 910 may press the thermal interface material 904 placed on the plurality of second electronic components 950. By the pressing, the solder paste 970 for electrical connection of the plurality of second electronic components 950 may be pressed. As the solder paste 970 is pressed, a short circuit may be caused. Overcurrent caused by the short circuit may cause heat generation of electronic components, whereby damage or malfunction of the electronic device 101 may occur.

According to an embodiment, a short circuit due to pressing of the solder paste 470 may be prevented by a structure in which the first electronic component 440 is disposed on the first printed circuit board 410. As shown in FIG. 8, when the plurality of second electronic components 450 press the thermal interface material 510, the solder paste 470 does not exist under the thermal interface material 510, and thus such a short circuit may not occur.

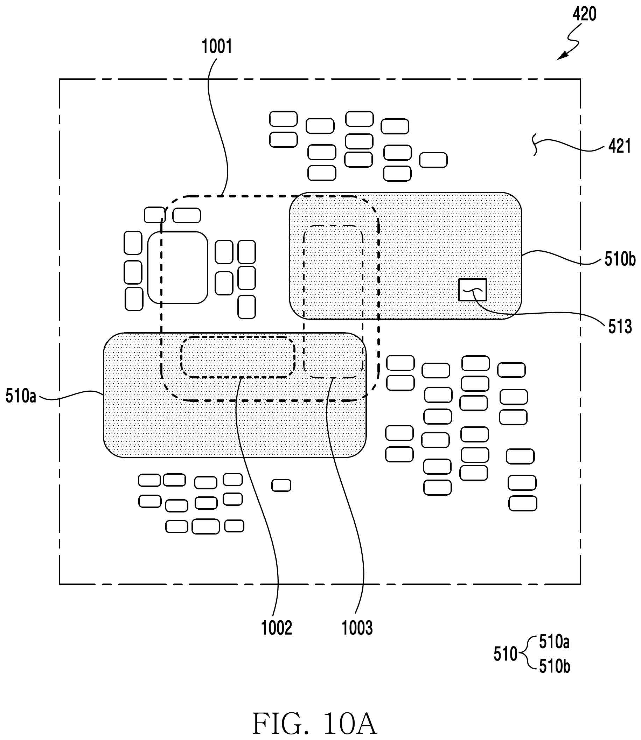

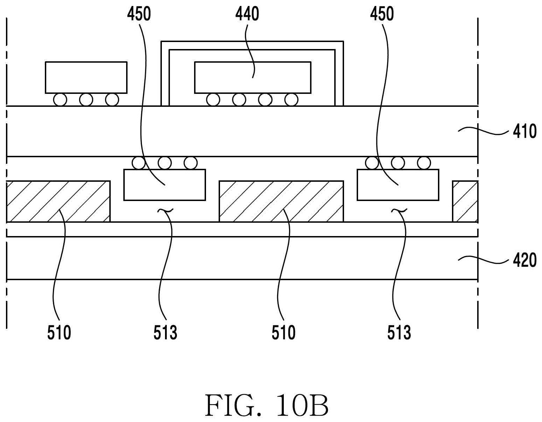

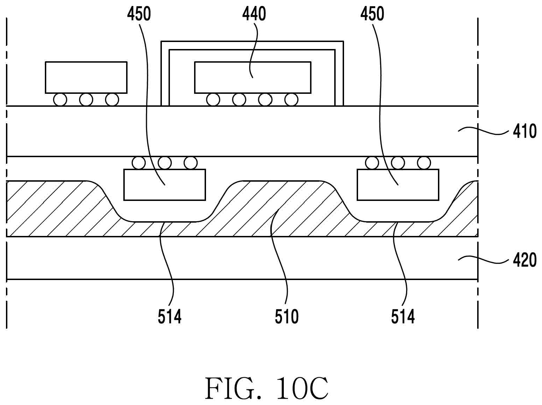

FIG. 10A is a front view of a third surface of a second printed circuit board. FIG. 10B schematically illustrates a printed circuit board including a thermal interface material in which an opening is formed. FIG. 10C schematically illustrates a printed circuit board including a thermal interface material in which a recess is formed.

According to an embodiment, a plurality of second electronic components (e.g., a plurality of second electronic components 450 of FIG. 8) disposed on a second surface (e.g., the second surface 412 of FIG. 8) of a first printed circuit board (e.g., the first printed circuit board 410 of FIG. 8) may be passive elements. For example, the passive elements may be capacitors and/or inductors included within a front-end module including duplexers (FEMid), a power amplifier (PA) and FEMid (PAMid), and/or a low noise amplifier (LNA) and PAMid (LPAMid), but the present disclosure is not limited thereto. When a passive element operates, the passive element may vibrate. For example, a capacitor is a component having capacitance and stores electric charge; thus, when a voltage is applied or a current flows, the capacitor may vibrate.

According to an embodiment, in order to diffuse heat generated from the plurality of second electronic components 450, the thermal interface material 510 may come into contact with the plurality of second electronic components 450. While the thermal interface material 510 is in contact with the plurality of second electronic components, when the plurality of second electronic components 450 vibrate, noise may be caused by repeated contact between the thermal interface material 510 and the plurality of second electronic components 450. The noise may reduce audio quality of the electronic device 101. For example, the electronic device 101 may include a speaker. The speaker may generate an audio signal based on vibration of a diaphragm. An audio signal provided from the speaker inside the electronic device may be provided to the outside of the electronic device 101 through an audio duct. In a case where the noise is caused when the plurality of second electronic components 450 vibrate, the audio signal provided through the audio duct may be distorted, or the audio signal may be provided together with the noise, thereby deteriorating the quality of the audio signal.

According to an embodiment, the thermal interface material 510 may be spaced apart from at least one electronic component generating vibration among the plurality of second electronic components 450 in order to reduce quality degradation of the audio signal. For example, the thermal interface material 510 may not come into contact with at least one electronic component among the plurality of second electronic components 450.

Referring to FIG. 10A, the thermal interface material 510 may be divided into a plurality of portions so as not to come into contact with at least one electronic component among the plurality of second electronic components 450. For example, the thermal interface material 510 may include a first portion 510a and a second portion 510b. The second portion 510b may be spaced apart from the first portion 510a. In order to diffuse the heat generated from the first electronic component 440, the thermal interface material 510 may come into contact with at least a portion of an area 1001 on the third surface 421 overlapping an area on the first surface 411 where the first electronic component 440 is disposed. For example, the first electronic component 440 may include an AP including a CPU and a GPU. The CPU and the GPU may be implemented as circuits logically divided within the AP. Since a large amount of heat is generated from the CPU and the GPU, the thermal interface material 510 may come into contact with at least a portion of the area 1002 on the third surface 421 corresponding to the CPU and the area 1003 on the third surface 421 corresponding to the GPU. The portion spaced apart between the first portion 510a and the second portion 510b may correspond to an electronic component generating vibration during operation among the plurality of second electronic components 450. As the thermal interface material 510 is divided into a plurality of portions (e.g., the first portion 510a and the second portion 510b) and a space between the plurality of portions corresponds to the electronic component generating vibration among the plurality of second electronic components 450, the thermal interface material 510 may be spaced apart from the electronic component generating vibration. Since the thermal interface material 510 is spaced apart from the electronic component, even if the electronic component vibrates, the noise due to the contact between the thermal interface material 510 and the electronic component may be reduced. As the noise is reduced, degradation of the audio signal provided from the electronic device 101 may be reduced.

According to an embodiment, the thermal interface material 510 may include an opening 513. The opening 513 may correspond to an electronic component generating vibration among the second electronic components 450. For example, in a case that it is difficult for the thermal interface material 510 to be spaced apart from the electronic component, the opening 513 may be formed by removing a portion of the thermal interface material 510 overlapping the electronic component. The electronic component may be located within the opening 513. Referring to FIG. 10B, the opening 513 may be formed by removing a portion of the thermal interface material 510. The opening 513 may correspond to each of the plurality of second electronic components 450, or may correspond to at least one electronic component generating vibration among the plurality of second electronic components 450. At least one of the plurality of second electronic components 450 may be disposed within the opening 513 such that it does not come into contact with the thermal interface material 510. Since the thermal interface material 510 is spaced apart from the electronic component via the opening 513, the noise due to the contact between the thermal interface material 510 and the electronic component may be reduced even if the electronic component vibrates. As the noise is reduced, degradation of the audio signal provided from the electronic device 101 may be reduced.

Referring to FIG. 10C, the thermal interface material 510 may include a recess 514 so as to be spaced apart from the plurality of second electronic components 450. For example, the recess 514 may correspond to each of the plurality of second electronic components 450 or may correspond to an electronic component generating vibration among the plurality of second electronic components 450. The plurality of second electronic components 450 may be spaced apart from the thermal interface material 510 without contacting the thermal interface material 510, by the recess 514. Since the thermal interface material 510 is spaced apart from the electronic component through the recess 514, the noise caused by contact between the thermal interface material 510 and the electronic component may be reduced even if the electronic component vibrates. According to the reduction in the noise, deterioration of the audio signal provided from the electronic device 101 may be reduced.

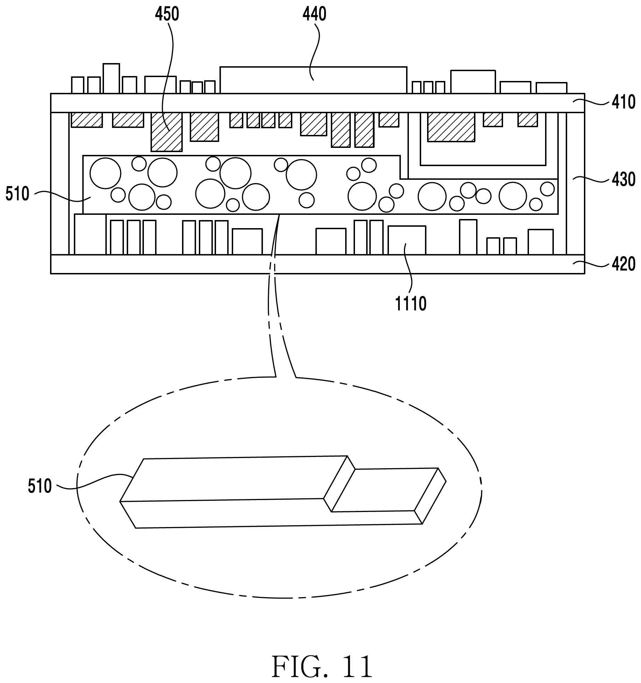

FIG. 11 illustrates a thermal interface material having a shape corresponding to outer surfaces of a plurality of second electronic components.

Referring to FIG. 11, each of the plurality of second electronic components 450 may have a different thickness. For example, the thicknesses of the plurality of second electronic components 450 may not all be uniform and may be independent. The plurality of second electronic components 450 disposed on the second surface 412 may be located within the space surrounded by the first printed circuit board 410, the second printed circuit board 420, and the interposer 430.

According to an embodiment, the thermal interface material 510 may be manufactured in a shape corresponding to outer surfaces of the plurality of second electronic components 450. For example, in the case of a four-sided mounting structure, a fourth electronic component 1110 may be disposed on the third surface 421 of the second printed circuit board 420. In a case where the thicknesses of each of the plurality of second electronic components 450 are different, a step may be formed on the outer surfaces of the plurality of second electronic components 450.

According to an embodiment, the thermal interface material 510 may be manufactured in a shape corresponding to the outer surfaces of the second electronic components 450 in order to increase a contact area with the plurality of second electronic components 450. For example, the outer surface of the thermal interface material 510 facing the plurality of second electronic components 450 may correspond to the outer surfaces of the plurality of second electronic components 450. When the thermal interface material 510 is disposed between the first printed circuit board 410 and the second printed circuit board 420, in a case where it has a shape corresponding to the outer surfaces of the plurality of second electronic components 450, the contact area between the plurality of second electronic components 450 and the thermal interface material 510 may be increased. This increase in contact area improves heat diffusion, thereby enhancing the heat dissipation effect.

FIG. 12A illustrates a printed circuit board before a thermal interface material is disposed. FIG. 12B illustrates a printed circuit board on which a thermal interface material is coated. FIG. 12C illustrates a printed circuit board after a bonding process is completed.

Referring to FIG. 12A, a thickness T1 of the interposer 430 may be about 0.79 mm. A thickness T2 of the solder paste 470 may be about 0.08 mm. A thickness T3 of the plurality of second electronic components 450 disposed on the second surface 412 of the first printed circuit board 410 may be about 0.8 mm. The aforementioned numerical values are merely an example, and the present disclosure is not limited thereto. In order for a thermal interface material (e.g., the thermal interface material 510 of FIG. 12B) disposed between the first printed circuit board 410 and the second printed circuit board 420 to come into contact with the plurality of second electronic components 450, a thickness of the thermal interface material 510 may be about 0.07 mm (0.79 mm + 0.08 mm - 0.8 mm) or more.

Referring to FIG. 12B, a maximum thickness of the thermal interface material 510 may be greater than a minimum distance between the plurality of second electronic components 450 from the third surface 421. For example, the thickness T1 of the interposer 430 may be about 0.79 mm, and the thickness T2 of the solder paste 470 may be about 0.08 mm. A thickness T4 of the thermal interface material 510 may be greater than a gap D between the thickest electronic component among the plurality of second electronic components 450 and the third surface 421, when the interposer 430 and the solder paste 470 come into contact with each other. For example, in a case where the thickness T3 of the thickest electronic component among the plurality of second electronic components 450 is about 0.8 mm, the thermal interface material 510 may come into contact with the plurality of second electronic components 450 when its thickness T4 is about 0.07 mm (0.79 mm + 0.08 mm - 0.8 mm) or more; however, the thermal interface material 510 may overlap at least one of the plurality of second electronic components 450 by having a thickness of about 0.18 mm. In a case where the thickness T4 of the thermal interface material 510 exceeds about 0.18 mm (e.g., about 0.22 mm), the interposer 430 may not be properly bonded or the first printed circuit board 410 may be misaligned, by a repulsive force by the thermal interface material 510 in a process of bonding the first printed circuit board 410 to the second printed circuit board 420. According to an embodiment, a thickness T5 at which the thermal interface material 510 overlaps the plurality of second electronic components 450 may be limited to within a thickness at which bonding of the printed circuit board 400 is stably performed. For example, the overlapping thickness T5 may be about 90 µm to about 130 µm, and may be less than 150 µm.

Referring to FIG. 12C, the thickness T5 at which the thermal interface material 510 and the thickest electronic component among the plurality of second electronic components 450 overlap may be about 0.11 mm (0.18 mm - 0.07 mm). As the thermal interface material 510 overlaps the plurality of second electronic components 450, the plurality of second electronic components 450 may press the thermal interface material 510 in the bonding process. The thermal interface material 510, which undergoes a phase change into a semi-solid phase or a liquid phase at the temperature of the reflow process, may penetrate between the plurality of second electronic components 450 as a result of being pressurized by the plurality of second electronic components 450.

In a case where the thermal interface material 510 is located too close to the interposer 430, the interposer 430 may not be properly bonded due to a repulsive force of the thermal interface material 510 pushing the first printed circuit board 410 during the bonding process, and thus a portion of the phase-changed thermal interface material 510 may leak between the first printed circuit board 410 and the second printed circuit board 420. In order to reduce the leakage, the thermal interface material 510 may be spaced apart by a certain distance or more from the interposer 430 or an electronic component 451 disposed closest to the interposer 430 among the plurality of second electronic components 450. According to an embodiment, the thermal interface material 510 may be spaced apart from the interposer 430 by a first distance 1201 or more. For example, the first distance 1201 may be about 3 mm, but is not limited thereto. According to an embodiment, the thermal interface material 510 may be spaced apart from the electronic component 451 disposed closest to the interposer 430 among the plurality of second electronic components 450 by a second distance 1202 or more. For example, the second distance 1202 may be about 1.5 mm, but is not limited thereto.

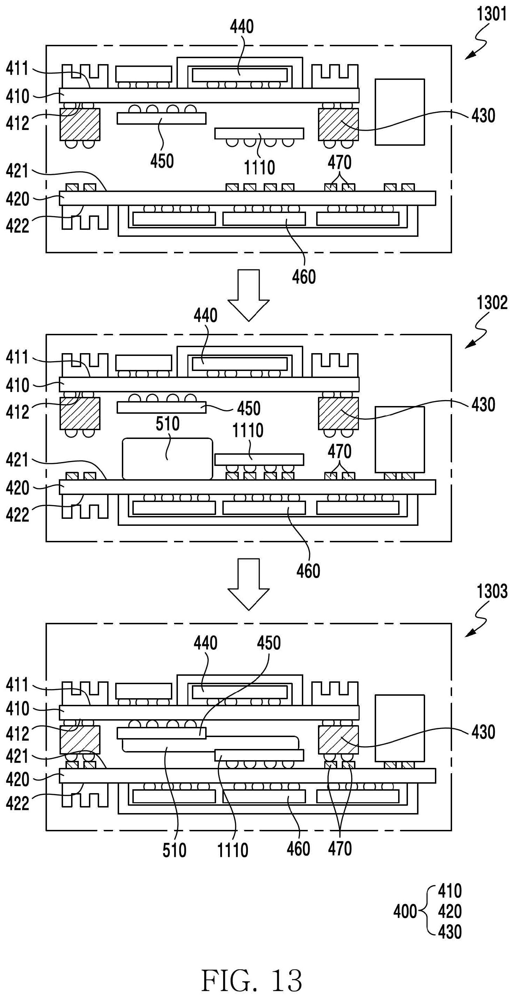

FIG. 13 illustrates a manufacturing process of a printed circuit board according to an embodiment.

A first state 1301 of FIG. 13 illustrates a state of the printed circuit board 400 according to an embodiment before the thermal interface material 510 is disposed. Referring to FIG. 13, the printed circuit board 400 according to an embodiment may have a four-sided mounting structure. For example, the first electronic component 440 may be disposed on the first surface 411 of the first printed circuit board 410. The plurality of second electronic components 450 may be disposed on the second surface 412 of the first printed circuit board 410. The third electronic component 460 may be disposed on the third surface 421 of the second printed circuit board 420. The fourth electronic component 1110 may be disposed on the fourth surface 422 of the second printed circuit board 420. The plurality of second electronic components 450 and the fourth electronic component 1110 may be disposed in the internal space of the printed circuit board 400 surrounded by the first printed circuit board 410, the second printed circuit board 420, and the interposer 430.

According to an embodiment, in order to reduce a short circuit due to pressing of the thermal interface material 510, the plurality of second electronic components 450 may be arranged to be offset from the fourth electronic component 1110. For example, the plurality of second electronic components 450 and the fourth electronic component 1110 may be disposed at positions that do not face each other.

A second state 1302 of FIG. 13 illustrates a state of the printed circuit board 400 according to an embodiment, in which the thermal interface material 510 is disposed. The solid-phase thermal interface material 510 may be disposed on the third surface 421 of the second printed circuit board 420. The thermal interface material 510 may be disposed on an area of the third surface 421 facing the plurality of second electronic components 450 so as to come into contact with the plurality of second electronic components 450. Since no electronic components are disposed on the third surface 421, the solder paste 470 for electrical connection of electronic components may not be disposed on the area of the third surface 421 facing the plurality of second electronic components 450.

In a case where any one of the plurality of second electronic components 450 and the fourth electronic component 1110 face each other, a short circuit may be caused by the pressing of the solder paste 470. For example, a force for pressing the thermal interface material 510 by at least one of the plurality of second electronic components 450 may be transferred to the fourth electronic component 1110. Due to this force, the solder paste 470 for connecting the fourth electronic component 1110 to the second printed circuit board 420 may be pressurized, thereby causing a short circuit.

According to an embodiment, as the plurality of second electronic components 450 and the fourth electronic component 1110 are arranged to be offset from each other, the plurality of second electronic components 450 may not overlap the fourth electronic component 1110. Referring to the second state 1302, even when the plurality of second electronic components 450 pressurize the thermal interface material 510, the solder paste 470 is not located under the thermal interface material 510, and therefore, a short circuit may not occur. The thermal interface material 510 may spread between the first printed circuit board 410 and the second printed circuit board 420 by being pressurized by the plurality of second electronic components 450.

A third state 1303 of FIG. 13 illustrates a state of the printed circuit board 400 according to an embodiment after the bonding process is performed. As the bonding process is performed, the solder paste 470 melts, and thus the interposer 430 and the second printed circuit board 420 may be bonded. The thermal interface material 510 may spread to the plurality of second electronic components 450 and the third electronic component 460 by a phase change from a solid phase to a semi-solid phase or a liquid phase. When the thermal interface material 510 is pressurized, the solder paste 470 does not exist under the thermal interface material 510, and thus a short circuit may not occur. Since the solder paste 470 for connecting the third electronic component 460 to the second printed circuit board 420 is not pressurized, a short circuit may not occur. According to an embodiment, even when the fourth electronic component 1110 is disposed on the third surface 421 of the second printed circuit board 420, the plurality of second electronic components 450 and the fourth electronic component 1110 may be arranged to be offset from each other, and therefore, a four-sided mounting structure may be possible.

According to an embodiment, in a case where at least one electronic component among the plurality of second electronic components 450 and the fourth electronic component 1110 at least partially face each other, the thermal interface material 510 may include an opening 513 in which the at least one electronic component and the fourth electronic component 1110 are included, in order to reduce a short circuit. Since the at least one electronic component and the fourth electronic component 1110 are located within the opening 513, no force may be transferred to the solder paste 470 through the thermal interface material 510. According to an embodiment, in order to reduce a short circuit, an electronic component having a relatively thin thickness among the plurality of second electronic components 450 may be disposed at a position facing the fourth electronic component 1110.

An electronic device 101 is provided. The electronic device 101 may include a first printed circuit board 410 including a first surface 411 and a second surface 412 opposite to the first surface 411. The electronic device 101 may include a second printed circuit board 420 including a third surface 421 facing the second surface 412 and a fourth surface 422 opposite to the third surface 421, the second printed circuit board 420 being spaced apart from the first printed circuit board 410. The electronic device 101 may include an interposer 430 disposed between the first printed circuit board 410 and the second printed circuit board 420 and forming a space between the first printed circuit board 410 and the second printed circuit board 420. The electronic device 101 may include a first electronic component 440 disposed on the first surface 411. The electronic device 101 may include a plurality of second electronic components 450 disposed on the second surface 412 and located within the space. The electronic device 101 may include a thermal interface material 510 (TIM) included within the space. The thermal interface material 510 may be spaced apart from at least one electronic component among the plurality of second electronic components 450.

For example, the thermal interface material 510 may include at least one of a recess 514 or an opening 513 corresponding to the at least one electronic component.

For example, the thermal interface material 510 may include a first portion 510a and a second portion 510b spaced apart from the first portion 510a. The at least one electronic component may correspond to a space between the first portion 510a and the second portion 510b.

For example, the at least one electronic component may include a passive element that generates vibration during operation. The thermal interface material 510 may be spaced apart from the passive element when the passive element vibrates.

For example, the size of the first printed circuit board 410 may be smaller than the size of the second printed circuit board 420.

For example, the electronic device 101 may include a display 201. The electronic device 101 may include a housing 210 including a first plate 202 supporting the display 201 and a second plate 211 opposite to the first plate 202. The printed circuit board 400 may be disposed within the housing 210. The first surface 411 may face a first direction D1 toward the display 201. The second surface 412 may face a second direction D2 toward the second plate 211.

For example, the thermal interface material 510 may form a heat transfer path for transferring heat emitted from the first electronic component 440 in the second direction D2.

For example, the electronic device 101 may further include another thermal interface material 520a disposed on the first electronic component 440. The other thermal interface material 520a may form another heat transfer path for transferring heat emitted from the first electronic component 440 in the first direction D1.

For example, the electronic device 101 may include a third electronic component 460 disposed on the fourth surface 422. The electronic device 101 may include a fourth electronic component 1110 disposed on the third surface 421 and positioned within the space. The plurality of second electronic components 450 may be arranged to be offset from the fourth electronic component 1110.

For example, the electronic device 101 may include a third electronic component 460 disposed on the fourth surface 422. The electronic device 101 may include a fourth electronic component 1110 disposed on the third surface 421 and positioned within the space. The thermal interface material 510 may include an opening 513 formed in a partial space within the space occupied by the plurality of second electronic components 450 and the fourth electronic component 1110.

For example, the thermal interface material 510 may include a phase change material.

For example, the thermal interface material 510 may be attached to at least one adhesive layer 530 attached on the third surface 421.

For example, an outer surface of the thermal interface material 510 may be formed to correspond to outer surfaces of the plurality of second electronic components 450.

For example, the thermal interface material 510 may be spaced apart from the interposer 430 by a first distance 1201 or more.

For example, the thermal interface material 510 may be spaced apart from the electronic component 451 disposed closest to the interposer 430 among the plurality of second electronic components 450 by a second distance 1202 or more.

For example, a maximum thickness of the thermal interface material 510 may be greater than a minimum distance from the third surface 421 between the plurality of second electronic components 450.

An electronic device 101 is provided. The electronic device 101 may include a display 201 facing a first direction D1. The electronic device 101 may include a housing 210 including a first plate 202 supporting the display 201 and a second plate 211 facing a second direction D2 opposite to the first direction D1. The electronic device 101 may include a first printed circuit board 410 including a first surface 411 facing the first direction D1 and a second surface 412 facing the second direction D2, the first printed circuit board 410 being disposed within the housing 210. The electronic device 101 may include a second printed circuit board 420 including a third surface 421 facing the first direction D1 and a fourth surface 422 facing the second direction D2, the second printed circuit board 420 being spaced apart from the first printed circuit board 410 in the second direction D2. The electronic device 101 may include an interposer 430 disposed between the first printed circuit board 410 and the second printed circuit board 420 and forming a space between the first printed circuit board 410 and the second printed circuit board 420. The electronic device 101 may include a first electronic component 440 disposed on the first surface 411. The electronic device 101 may include a plurality of second electronic components 450 disposed on the second surface 412 and located within the space. The electronic device 101 may include a thermal interface material 510 (TIM) included within the space. The thermal interface material 510 may include at least one of a recess 514 or an opening 513 corresponding to the plurality of second electronic components 450 so as to be spaced apart from the plurality of second electronic components 450.

For example, the size of the first printed circuit board 410 may be smaller than the size of the second printed circuit board 420.

For example, the thermal interface material 510 may form a heat transfer path for transferring heat emitted from the first electronic component 440 in the second direction D2.

For example, the electronic device 101 may further include a fourth electronic component 1110 disposed on the third surface 421 and positioned within the space. The plurality of second electronic components 450 may be arranged to be offset from the fourth electronic component 1110.

The electronic device according to various embodiments disclosed herein may be one of various types of electronic devices. The electronic devices may include, for example, a portable communication device (e.g., a smartphone), a computer device, a portable multimedia device, a portable medical device, a camera, a wearable device, or a home appliance. In an embodiment of the disclosure, the electronic devices are not limited to those described above.

It should be appreciated that various embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B", "A, B, or C", "at least one of A, B, and C", and "at least one of A, B, or C" may include any one of, or all possible combinations of the items enumerated together in a corresponding one of the phrases. As used herein, such terms as "1st" and "2nd", or "first" and "second" may be used to simply distinguish a corresponding component from another, and does not limit the components in other aspect e.g., importance or order. In a case where an element (e.g., a first element) is referred to, with or without the term "operatively" or "communicatively", as "coupled" or "connected" to/with another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may be interchangeably used with other terms, for example, 'logic', 'logic block', 'part', or 'circuit'. A module may be a single integral component, or a minimum unit or part thereof, adapted to perform one or more functions. For example, according to an embodiment, the module may be implemented in a form of an application-specific integrated circuit (ASIC).

Various embodiments of the disclosure may be implemented as software (e.g., the program 140) including one or more instructions that are stored in a storage medium (e.g., an internal memory 136 or an external memory 138) that is readable by a machine (e.g., the electronic device 101). For example, a processor (e.g., the processor 120) of the machine (e.g., the electronic device 101) may invoke at least one of the one or more instructions stored in the storage medium, and execute it. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semipermanently stored in the storage medium and where the data is temporarily stored in the storage medium.

According to an embodiment, a method according to various embodiments disclosed herein may be included and provided in a computer program product. The computer program product may be traded as a product between a seller and a buyer. The computer program product may be distributed in the form of a machine-readable storage medium (e.g., a compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory 130 of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device comprising:
a first printed circuit board, PCB, including:
a first surface, and
a second surface opposite to the first surface;
a second PCB spaced apart from the first PCB, the second PCB including:
a third surface facing the second surface, and
a fourth surface opposite to the third surface;
an interposer disposed between the first PCB and the second PCB and forming a space between the first PCB and the second PCB;
a first electronic component disposed on the first surface;
a plurality of second electronic components disposed on the second surface and positioned within the space; and
a thermal interface material, TIM, included within the space,
wherein the TIM is spaced apart from at least one electronic component among the plurality of second electronic components.

2. The electronic device of claim 1, wherein the TIM includes at least one of a recess or an opening corresponding to the at least one electronic component.

3. The electronic device of claim 1 or 2, wherein the TIM includes:
a first portion; and
a second portion spaced apart from the first portion,
wherein the at least one electronic component corresponds to a space between the first portion and the second portion.

4. The electronic device of any one of claims 1 to 3,
wherein the at least one electronic component includes a passive element that generates vibration during operation, and
wherein the TIM is spaced apart from the passive element when the passive element vibrates.

5. The electronic device of any one of claims 1 to 4, wherein a size of the first PCB is smaller than a size of the second PCB.

6. The electronic device of any one of claims 1 to 5, further comprising:
a display; and
a housing including:
a first plate supporting the display, and
a second plate opposite to the first plate,
wherein the PCB is disposed within the housing,
wherein the first surface faces a first direction toward the display, and
wherein the second surface faces a second direction toward the second plate.

7. The electronic device of claim 6, wherein the TIM forms a heat transfer path for transferring heat emitted from the first electronic component in the second direction.

8. The electronic device of claim 6 or 7, further comprising another TIM disposed on the first electronic component,
wherein the another TIM forms another heat transfer path for transferring heat emitted from the first electronic component in the first direction.

9. The electronic device of any one of claims 1 to 8, further comprising:
a third electronic component disposed on the fourth surface; and
a fourth electronic component disposed on the third surface and positioned within the space,
wherein the plurality of second electronic components are arranged to be offset from the fourth electronic component.

10. The electronic device of any one of claims 1 to 9, further comprising:
a third electronic component disposed on the fourth surface; and
a fourth electronic component disposed on the third surface and positioned within the space,
wherein the TIM includes an opening formed in a partial space within the space occupied by the plurality of second electronic components and the fourth electronic component.

11. The electronic device of any one of claims 1 to 10, wherein the TIM comprises a phase change material.

12. The electronic device of any one of claims 1 to 11, wherein the TIM is attached to at least one adhesive layer attached on the third surface.

13. The electronic device of any one of claims 1 to 12, wherein an outer surface of the TIM is formed to correspond to outer surfaces of the plurality of second electronic components.

14. The electronic device of any one of claims 1 to 13, wherein the TIM is spaced apart from the interposer by at least a first distance.

15. The electronic device of any one of claims 1 to 14, wherein the TIM is spaced apart by at least a second distance from an electronic component disposed closest to the interposer among the plurality of second electronic components.
